# EUROPEAN PATENT SPECIFICATION

(11) **EP 4 250 378 B1**
(45) Date of publication and mention of the grant of the patent: **24.12.2025**
(21) Application number: 22164120.2
(22) Date of filing: 24.03.2022
(51) Int. Cl.: H10H 29/80, H10H 29/01, H10H 20/01, H10H 29/14, H10H 29/49, H10H 29/24, H10H 29/39, H10H 29/85, H01L 25/16

(54) **METHOD FOR FORMING RESONANT CAVITY LIGHT EMITTING ELEMENTS AND OPTICAL DEVICE COMPRISING SAID ELEMENTS**
VERFAHREN ZUR HERSTELLUNG VON LICHTEMITTIERENDEN ELEMENTEN MIT RESONANZHOHLRAUM UND OPTISCHE VORRICHTUNG MIT DIESEN ELEMENTEN
PROCÉDÉ DE FORMATION D'ÉLÉMENTS ÉLECTROLUMINESCENTS À CAVITÉ RÉSONANTE ET DISPOSITIF OPTIQUE COMPRENANT LESDITS ÉLÉMENTS

(43) Date of publication of application: 27.09.2023
(73) Proprietor: Micledi Microdisplays BV, 3000 Leuven (BE)
(72) Inventor: Buscemi, Giuseppe, 3000 Leuven (BE); Steudel, Soeren, 3020 Herent (BE)
(74) Representative: Körfer, Thomas

(56) References cited:
- US-A1- 2021 320 229
- PARK JINJOO ET AL: "Electrically driven mid-submicrometre pixelation of InGaN micro-light-emitting diode displays for augmented-reality glasses", NATURE PHOTONICS, NATURE PUBLISHING GROUP UK, LONDON, vol. 15, no. 6, 25 March 2021 (2021-03-25), pages 449 - 455, XP037469833, ISSN: 1749-4885, [retrieved on 20210325], DOI: 10.1038/S41566-021-00783-1
- PARK JINJOO ET AL: "Supplementary information for: Electrically driven mid-submicrometre pixelation of InGaN micro-light-emitting diode displays for augmented-reality glasses (in the format provided by the authors)", vol. 15, no. 6, 25 March 2021 (2021-03-25), London, pages 449 - 455, XP055960926, ISSN: 1749-4885, Retrieved from the Internet <URL:http://www.nature.com/articles/s41566-021-00783-1> DOI: 10.1038/s41566-021-00783-1

## Description

The invention relates to cavity length definition in complementary metal-oxide-semiconductor (CMOS) processing and integration of resonant cavity light emitting elements, e.g. resonant cavity light emitting diode (RCLED), with wafer-to-wafer (W2W) hybrid bonding backplane, especially for micro-LED displays.

Generally, RCLEDs comprise a structure where the active region is sandwiched between two reflective mirrors with a cavity length of one wavelength or a wavelength multiple of the emitting light. The resulting resonance amplifies the spontaneous emission perpendicular to the surface. These characteristics increase the overall system efficiency, especially for augmented reality (AR) and similar applications, compared to conventional LEDs. For example, the document US 7,825,006 B2 presents a process to fabricate RCLEDs on SiC substrate by implementing a Group-III nitride epitaxial semiconductor structure with two reflective mirrors. The article by Jinjoo Park et al., titled: "Electrically driven mid-submicrometre pixelation of InGaN micro-light-emitting diode displays for augmented-reality glasses", Nature Photonics, Vol. 15, No. 6, 25 March 2021, pages 449-455, discloses InGaN-based micro-LEDs suitable for displays in AR-glasses. In particular, monolithic integration of tailored ion implantation is reported for pixelated InGaN/GaN LEDs with thin film transistor (TFT) driving, resonant-cavity architecture, and quantum dot (QD) conversion for full-colour images.

However, the definition of the cavity length is a crucial parameter to tune, especially to define RCLED performances, because it maximizes the integrated intensity. Furthermore, Group-III nitride based RCLEDs require complex fine-tuning for cavity length definition. Moreover, conventional RCLED manufacturing process and backplane integration require separate CMOS fabrication process.

Accordingly, an object of the invention is to provide a method for forming resonant cavity light emitting elements and an optical device that can address the aforementioned limitations, especially to perform cavity length definition prior and during processing in a full CMOS environment.

The object of the present invention is solved by the features of the first independent claim for the method, and by the features of the second independent claim for the optical device. The dependent claims contain further developments of the present invention.

According to a first aspect of the invention, a method is provided for forming resonant cavity light emitting elements. The method comprises a step of forming a first structure comprising a first substrate, an etch stop layer, light emitting epitaxial structure, an optically transparent conductive oxide layer, and a second substrate dielectrically bonded to the optically transparent conductive oxide layer. The method further comprises a step of etching from the first substrate up to the etch stop layer to etch away the first substrate.

Additionally, the method comprises a step of forming a plurality of light emitting mesa modules, each having a metal layer and/or a dielectric structure deposited on the etch stop layer. Furthermore, the method comprises a step of hybrid bonding the previously etched first structure to a carrier substrate to form a second structure. Furthermore, the method comprises a step of etching from the second substrate up to the optically transparent conductive oxide layer. Moreover, the method comprises a step of depositing a distributed Bragg reflector on top of the optically transparent conductive oxide layer, thereby forming the resonant cavity light emitting elements.

Therefore, the invention facilitates the manufacturing and integration of RCLEDs in a full CMOS environment with W2W hybrid bonding integration backplane, especially suitable for micro-LED displays. The invention further provides a scheme to effectively and accurately perform the cavity length definition prior and during processing, especially by introducing the etch stop layer in the epitaxial stack. In this regard, the etch stop layer effectively supports the etching process as well as defines one side of the cavity, where the other side is the conductive oxide layer surface and/or the distributed Bragg reflector interface.

Preferably, the shape of a cross-section of the light emitting mesa modules is a slope shape. Additionally or alternately, the light emitting mesa modules are formed in a parabolic or semi-parabolic shape. Furthermore, the method may comprise a step of passivating exposed areas or sidewalls along the light emitting mesa modules. In this regard, the passivating step comprises performing atomic layer deposition and/or ion implantation and/or bombarding with plasma. The application of a passivation layer advantageously protects the mesa sidewalls during subsequent processing steps and further prevents current leakage around the emission layer.

Preferably, a thickness of the etch stop layer, the light emitting epitaxial structure, and the optically transparent conductive oxide layer, collectively, defines a cavity length for the resonant cavity light emitting elements, preferably corresponding to one wavelength of a light to be emitted by the resonant cavity light emitting elements. In other words, the etch stop layer, the light emitting epitaxial structure, and the optically transparent conductive oxide layer collectively form a cavity structure, and the thickness of said cavity structure defines the cavity length, preferably corresponds to one wavelength of the light to be emitted.

Preferably, the formation of the first structure comprises a step of growing a buffer layer, the etch stop layer, the light emitting epitaxial structure, and the optically transparent conductive oxide layer, successively, on the first substrate. The light emitting epitaxial structure comprises a first highly-doped layer, an emission layer, and a second highly-doped layer, successively. In this regard, the etch stop layer is provided between the buffer layer and the first highly-doped layer. The formation of the first structure further comprises a step of dielectric bonding to the second substrate at the optically transparent conductive oxide layer to form the first structure.

Preferably, the buffer layer is an n-doped buffer layer, especially an n-type Gallium Nitride (nGaN) layer. The first highly-doped layer is an n-doped layer, especially an n-type Gallium Nitride (nGaN) layer. The second highly-doped layer is a p-doped layer, especially a p-type Gallium Nitride (pGaN) layer. The emission layer is a quantum well layer, especially an Indium Gallium Nitride (InGaN) and/or Gallium Nitride (GaN) based multiple quantum well (MQW) multi-layer. Therefore, the processing and fine-tuning of GaN-based RCLEDs, especially on a CMOS processing flow, are advantageously incorporated.

Preferably, the etch stop layer comprises or is an Indium Gallium Nitride (InGaN) and/or Aluminum Indium Gallium Nitride (AlInGaN) and/or Aluminum Gallium Nitride (AlGaN) layer. In other words, the etch stop layer comprises a material from the group InGaN, AlInGaN and AlGaN. Alternatively, the etch stop layer comprises or is a dielectric layer, preferably an oxide based dielectric layer (e.g. Silica, SiO2).

Preferably, the formation of the second structure comprises the steps of flipping over the first structure, and hybrid bonding the first structure to the carrier substrate comprising a plurality of contact pads so as to bond the plurality of light emitting mesa modules with the respective contact pads. In this regard, the hybrid bonding refers to a bonding process that combines a dielectric bond with embedded metal to form interconnections.

Preferably, the optically transparent conductive oxide layer comprises or is a transparent oxide based alloy (e.g. Indium Tin Oxide, ITO). Advantageously, the optically transparent conductive oxide layer has the properties of adequate electrical conductivity and optical transparency, easy to be deposited as a thin film, and adequate chemical resistance to moisture.

Preferably, the metal layer comprises or is a Titanium layer and/or an Aluminum layer and/or bilayers thereof. More preferably, the metal layer comprises at least one Titanium layer and at least one Aluminum layer.

Alternatively, the metal layer comprises or is a plurality of conductive layers, preferably Titanium based oxide layers (e.g. Titanium Oxides, TiOx) and/or Hafnium based oxide layers (e.g. Hafnium Oxides, HfOx) and/or bilayers thereof. In other words, the metal layer may comprise or is a conductive distributed Bragg reflector.

Further alternatively, the metal layer comprises or is a plurality of dielectric layers and at least one metallic layer to form a hybrid optical reflector.

Preferably, the distributed Bragg reflector comprises or is a multi-layer oxide based reflector, preferably comprising Tantalum based oxide layers (e.g. Tantalum Pentoxide, Ta2O5) and/or Niobium based oxide layers (e.g. Niobium Pentoxide, Nb2O5) and/or Silicon based oxide layers (e.g. Silica, SiO2) and/or bilayers thereof.

For instance, a Silica layer and a Tantalum/Niobium oxide layer may be repeatedly stacked under quarter-wavelength conditions (based on the desired wavelength of the light to be emitted), and the reflectance or transmittance of the desired wavelength band may be increased by adjusting the thicknesses of individual layers and the number of stacked layers.

Preferably, the etching corresponds to a dry etching process and/or a chemical-mechanical planarization process and/or a combination thereof. Advantageously, a very fast processing scheme is incorporated that is easy to start and stop, and less sensitive to temperature.

Preferably, the etch stop layer has a thickness less than 20nm, preferably between 10nm to 20nm, more preferably between 10nm to 15nm.

According to a second aspect of the invention, an optical device is provided that comprises a plurality of resonant cavity light emitting elements. In this regard, each of the plurality of resonant cavity light emitting elements comprises a common carrier substrate, a metal layer hybrid bonded with the common carrier substrate, an etch stop layer on top of the metal layer, a first highly-doped layer on top of the etch stop layer, an emission layer on top of the first highly-doped layer, a second highly-doped layer on top of the emission layer, an optically transparent conductive oxide layer on top of the second highly-doped layer, and a distributed Bragg reflector on top of the optically transparent conductive oxide layer. The resonant cavity light emitting elements of the optical device in accordance with the present invention are formed by:
forming a first structure comprising a first substrate, the etch stop layer, a light emitting epitaxial structure comprising the first highly-doped layer, the emission layer and the second highly-doped layer, the optically transparent conductive oxide layer, and a second substrate dielectrically bonded to the optically transparent conductive oxide layer,
etching from the first substrate up to the etch stop layer to etch away the first substrate,
forming a plurality of light emitting mesa modules, each having the metal layer deposited on the etch stop layer,
hybrid bonding the previously etched first structure to the common carrier substrate to form a second structure,
etching from the second substrate up to the optically transparent conductive oxide layer, and
depositing the distributed Bragg reflector on top of the optically transparent conductive oxide layer.

Preferably, the etch stop layer, the first highly-doped layer, the emission layer, the second highly-doped layer, and the optically transparent conductive oxide layer are configured to define a cavity length for the resonant cavity light emitting elements, preferably corresponding to one wavelength of a light to be emitted by the resonant cavity light emitting elements.

It is to be noted that the optical device according to the second aspect corresponds to the method according to the first aspect and its implementation forms. Accordingly, the optical device of the second aspect achieves the same advantages and effects as the method of the first aspect and its respective implementation forms.

Exemplary embodiments of the invention are now further explained with respect to the drawings by way of example only, and not for limitation. In the drawings:
- Fig. 1: shows an exemplary embodiment of the method according to the first aspect of the invention;
- Fig. 2A: shows a first process step of an exemplary embodiment of the fabrication process;
- Fig. 2B: shows a second process step of the exemplary embodiment of the fabrication process;
- Fig. 2C: shows a third process step of the exemplary embodiment of the fabrication process;
- Fig. 2D: shows a fourth process step of the exemplary embodiment of the fabrication process;
- Fig. 2E: shows a fifth process step of the exemplary embodiment of the fabrication process;
- Fig. 2F: shows a sixth process step of the exemplary embodiment of the fabrication process;
- Fig. 2G: shows a seventh process step of the exemplary embodiment of the fabrication process;
- Fig. 2H: shows an eighth process step of the exemplary embodiment of the fabrication process;
- Fig. 2I: shows a ninth process step of the exemplary embodiment of the fabrication process;
- Fig. 2J: shows a tenth process step of the exemplary embodiment of the fabrication process; and
- Fig. 2K: shows an eleventh process step of the exemplary embodiment of the fabrication process.

Reference will now be made in detail to the embodiments of the present invention, examples of which are illustrated in the accompanying drawings. However, the following embodiments of the present invention may be variously modified and the range of the present invention is not limited by the following embodiments. The scope of the present invention is as defined by the appended claims. Reference signs for similar entities in different embodiments are partially omitted.

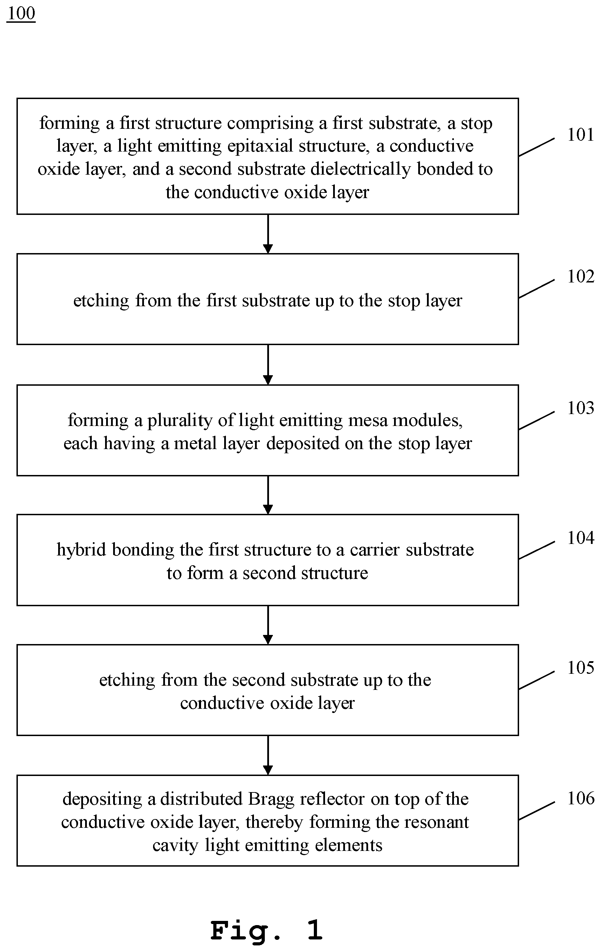

In Fig. 1, an exemplary embodiment of the method 100 according to the first aspect of the invention is illustrated. In a first step 101, a first structure is formed comprising a first substrate, an etch a stop layer, a light emitting epitaxial structure, an optically transparent conductive oxide layer, and
a second substrate dielectrically bonded to the conductive oxide layer. In a second step 102, etching is performed from the first substrate up to the etch stop layer. In a third step 103, a plurality of light emitting mesa modules are formed, each having a metal layer deposited on the etch stop layer.

In a fourth step 104, the previously etched first structure is hybrid bonded to a carrier substrate to form a second structure. In a fifth step 105, etching is performed from the second substrate up to the optically transparent conductive oxide layer. Finally, in a sixth step 106, a distributed Bragg reflector is deposited, especially for each light emitting mesa modules, on top of the optically transparent conductive oxide layer, thereby forming the resonant cavity light emitting elements.

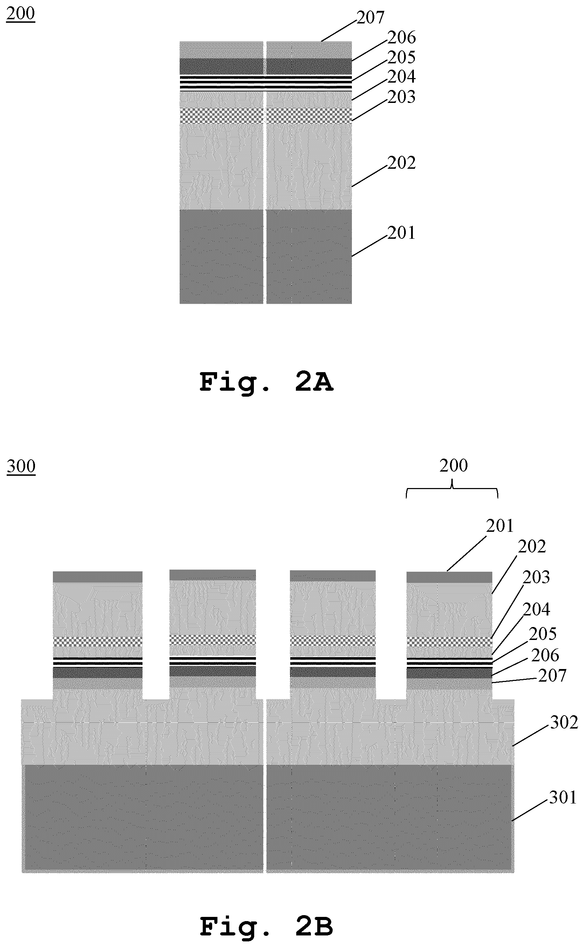

In Figs. 2A-2K, an exemplary embodiment of the fabrication process is illustrated. Particularly, in Fig. 2A, a first process step of the fabrication process is illustrated. The first process step corresponds to the formation of an epitaxial stack 200, especially by growing epitaxial layers on a first substrate 201 (e.g. silicon substrate). The epitaxial growth process may be performed by growing a buffer layer 202 comprising n-type GaN, hereinafter referred to as N-GaN buffer layer, followed by an etch a stop layer 203 comprising a material from the group InGaN, AlInGaN and AlGaN, having a thickness preferably between 10-20nm.

The process further facilitates the growth of a light emitting epitaxial structure or LED epitaxial structure, especially comprising an n-type GaN layer 204, hereinafter referred to as N-GaN layer, an emission layer or active layer or MQWs 205, and a p-type GaN layer 206, hereinafter referred to as P-GaN layer. As such, the etch stop layer 203 is provided within the epitaxial stack 200, especially between the N-GaN buffer layer 202 and the N-GaN layer 204. Moreover, an optically transparent conductive oxide layer 207, especially comprising Indium Tin Oxide and hereinafter referred to as ITO layer, is provided on top of the LED epitaxial structure, especially on top of the P-GaN layer 206.

In Fig. 2B, a second process step of the fabrication process is illustrated. Particularly, the second process step corresponds to the formation of a first structure 300 by flipping over and by means of dielectric bonding the epitaxial stack 200 with a second substrate 301 at the ITO layer 207. Hence, the first structure 300 comprises (from top to bottom direction as shown in Fig. 2B) the first substrate 201, the N-GaN buffer layer 202, the etch stop layer 203, the N-GaN layer 204, the emission layer 205, the P-GaN layer 206, the ITO layer 207, bonding dielectric or dielectric layer 302, and the second substrate 301. Preferably, the second substrate 301 is realized in a 300mm silicon wafer, especially with a thickness of 775nm.

This technique advantageously allows III-V integration on a CMOS fabrication. The process may be performed by realizing the epitaxial stack 200 on the incoming wafer, by depositing a bonding layer on the ITO layer 207, by dicing the wafer slighter larger than the LED optical area, by flipping and dielectric bonding to the 300mm silicon wafer 301.

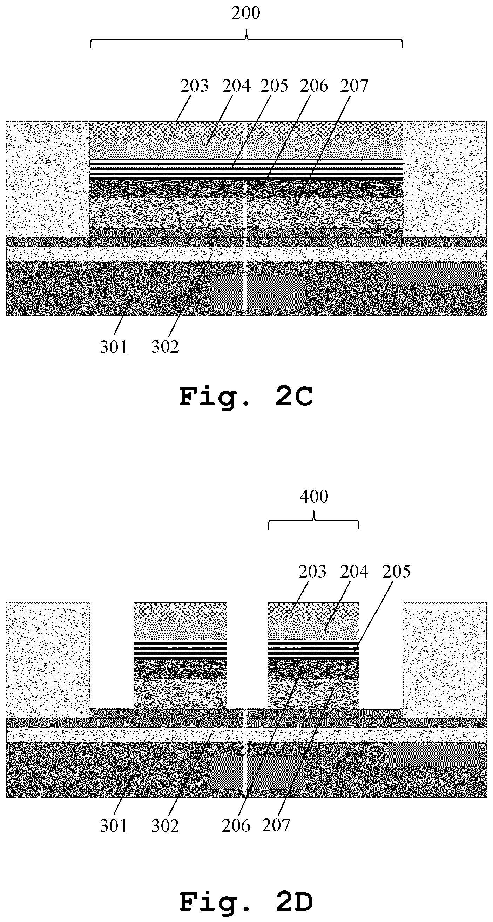

In Fig. 2C, a third process step of the fabrication process is illustrated. Particularly, the third process step corresponds to the planarization of the first structure 300. The process initiates the etching, especially dry etching, of the first structure 300 from the first substrate 201 side (i.e. from top to bottom direction of the first structure 300 as shown in Fig. 2B), up to the etch stop layer 203 to etch away or remove the first substrate 201 and the N-GaN buffer layer 202.

For instance, the third process step may initiate a step for etching the first substrate 201, followed by a step for dielectric deposition and planarization (e.g. chemical mechanical planarization, CMP) of the etched surface, followed by a step for etching the N-GaN buffer layer 202, followed by a step for dielectric deposition and planarization of the etched surface. The introduction of the etch stop layer 203 in the epitaxial stack 200 effectively allows the etching process and to stop the process, thereby defining one side of the cavity with a high accuracy.

In Fig. 2D, a fourth process step of the fabrication process is illustrated. Particularly, the fourth process step corresponds to the formation of mesa modules 400 on the first structure 300. The mesa modules 400 may be etched with a slope sidewall (e.g. by implementing a sloped mesa etch mask), and may comprise the etch stop layer 203, the N-GaN layer 204, the emission layer 205, the P-GaN layer 206, and the ITO layer 207.

The fourth process step may additionally perform passivation of the exposed areas or etched sidewalls of the mesa modules 400. In this regard, the passivation may comprise atomic layer deposition and/or ion implantation and/or bombarding with plasma. Alternatively, an oxide based passivation layer may be formed, such as a SiO2 layer and/or a combination of dielectric to form a DBR, which may act as a reflector to reflect the emitted light.

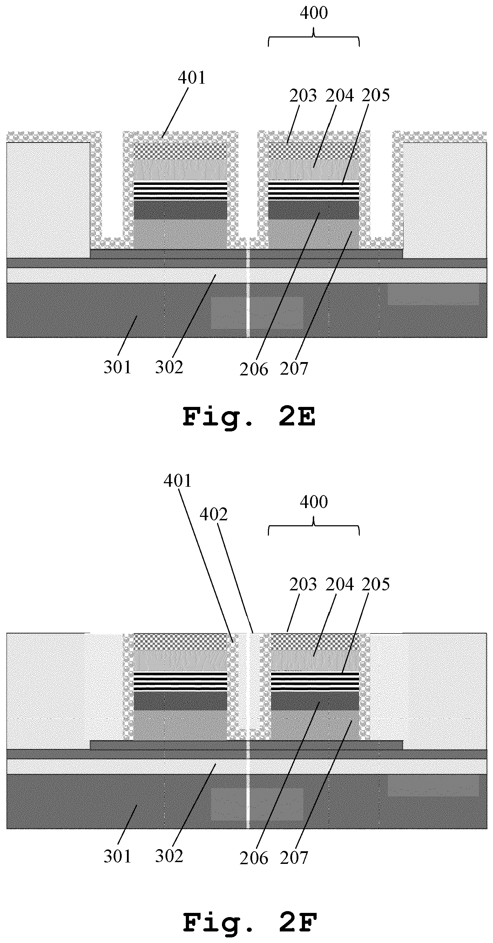

In Fig. 2E, a fifth process step of the fabrication process is illustrated. Particularly, the fifth process step corresponds to the dielectric insulation of the mesa modules 400. For instance, during the fifth process step, the mesa modules 400 are laterally etched in a Tetramethyl Ammonium Hydroxide solution (TMAH etching) to perform lateral anisotropic etching.

Afterwards, insulation films (e.g. Aluminium Oxide, Al2O3) are deposited, e.g. by means of atomic layer deposition. Further, dielectric films (e.g. Silicon Nitride, SiNx) are deposited, e.g. by means of atomic layer deposition. Hence, the insulation layer 401 may comprise multiple layers of insulation films and dielectric films. This achieves a high degree of electrical and optical isolation between the neighboring mesa modules 400.

In Fig. 2F, a sixth process step of the fabrication process is illustrated. Particularly, the sixth process step corresponds to the planarization of the mesa modules 400. In this regard, oxide deposition may be carried out (e.g. the oxide filling 402 between and/or around the mesa modules 400 as shown) followed by a CMP process for each of the mesa modules 400. The CMP process is preferably stopped at the etch stop layer 203.

As such, the introduction of the etch stop layer 203 in the epitaxial stack 200 further acts as a process stop layer for the CMP process, which simplifies the fine-tuning of the cavity length during the process to accurately define one side of the cavity.

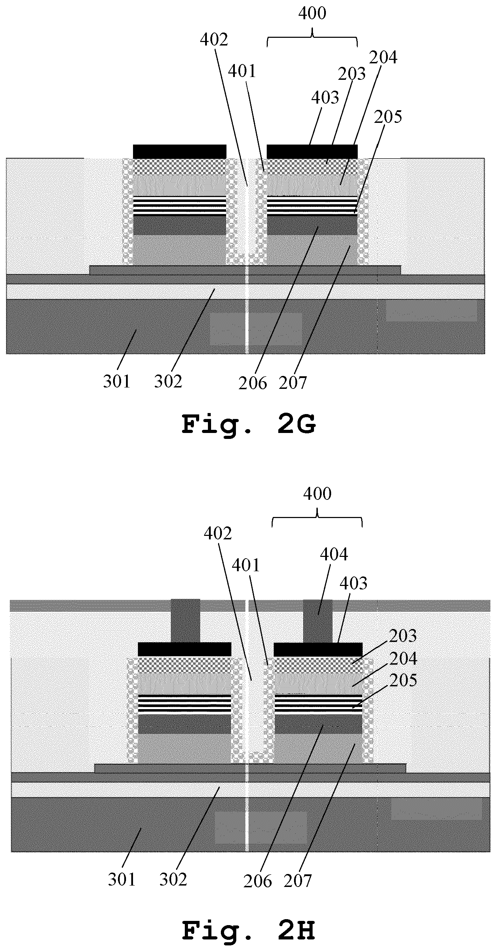

In Fig. 2G, a seventh process step of the fabrication process is illustrated. Particularly, the seventh process step corresponds to the metal layer 403 deposition on the mesa modules 400. In this regard, the metal layer 403 acts as a cavity mirror at one side of the cavity. For instance, the deposition of the metal layer 403 may include the deposition of an Aluminum layer or film or films followed by the deposition of a Titanium layer or film or films.

Alternatively, the metal layer 403 may be formed as a conductive distributed Bragg reflector. This can be achieved, e.g.**,** by depositing multiple conductive layers or films (e.g**.** TiOx, HfOx) to form a reflector with stacked conductive layers.

In Fig. 2H, an eighth process step of the fabrication process is illustrated. Particularly, the eighth process step corresponds to the formation of n-side contacts or N-contacts 404 on the mesa modules 400. Preferably, the N-contacts 404 are copper (Cu) contacts that are formed by means of a Cu-damascene process, followed by dielectric deposition.

Generally, the damascene process is an additive process that makes use of the etching of dielectrics instead of etching the metal/copper. At first, the dielectric is deposited and etched according to a defined photoresist pattern, with an optional step of barrier layer deposition. Subsequently, copper is deposited, e.g**.** by chemical vapor deposition, CVD, or by physical vapor deposition, PVD, with reflow, or in electrochemical/galvanic processes. Afterwards, the copper is polished by CMP. The damascene process described herein corresponds to a single damascene process. However, a dual damascene process can also be implemented within this fabrication process.

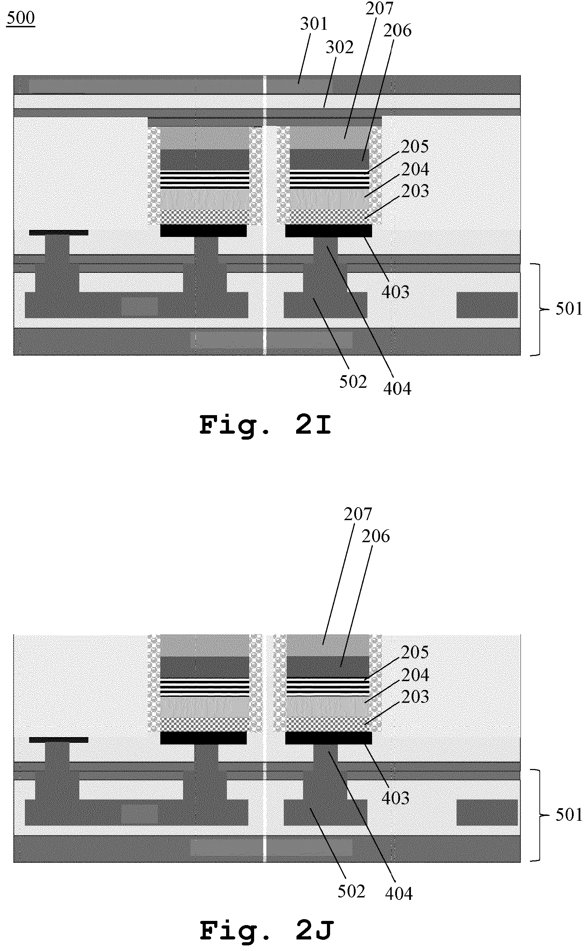

In Fig. 2I, a ninth process step of the fabrication process is illustrated. Particularly, the ninth process step corresponds to the formation of a second structure 500 by flipping over the first structure 300 after forming the N-contacts 404, and by hybrid bonding with a common carrier substrate 501.

The common carrier substrate 501 corresponds to a Si-CMOS backplane that comprises a plurality of contact pads 502. The respective mesa modules 400, especially the N-contacts 404 of the respective mesa modules 400 are bonded with the respective contact pads 502 of the Si-CMOS backplane.

It is to be noted that hybrid bonding generally forms an attachment that combines two different kinds of bonds, especially a dielectric bond and a metal bond, where the latter is usually embedded in a dielectric bonding surface. In particular, the process conditions may be chosen as for conventionally known bonding techniques, i.e. temperature, pressure, and so on. Additionally, a post bond annealing may be applied in order to improve the overall bond shear strength.

In Fig. 2J, a tenth process step of the fabrication process is illustrated. Particularly, the tenth process step corresponds to the exposure of the ITO surface, i.e. the other side of the cavity.

The process step includes the etching or removal of the second substrate 301 followed by the etching or removal of the bonding dielectric or dielectric layer 302. The removal of the second substrate 301 and/or the dielectric layer 302 may comprise grinding and/or dry etching and/or wet etching and/or CMP.

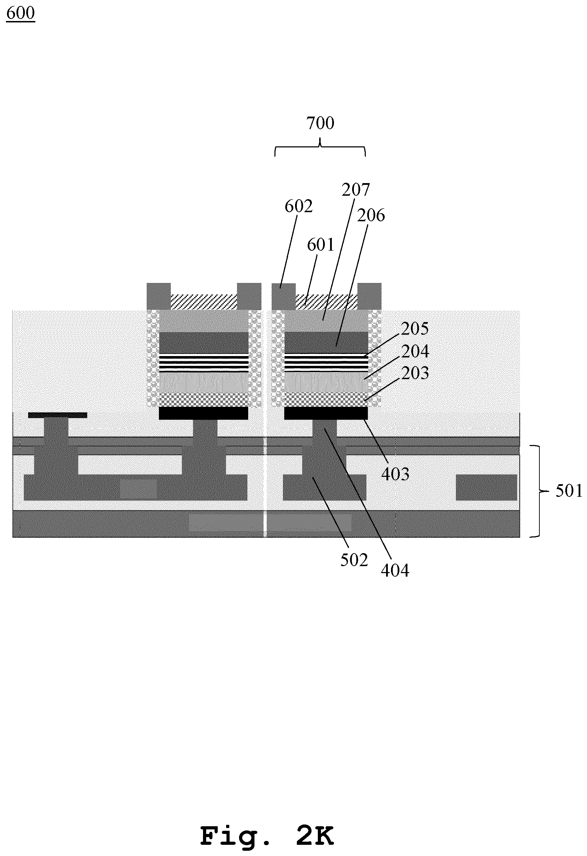

In Fig. 2K, an eleventh process step of the fabrication process is illustrated. Particularly, the eleventh process step corresponds to the deposition of the distributed Bragg reflector 601 and P-contacts 602 formation.

The process step may comprise the deposition of the distributed Bragg reflector 601, preferably adding an oxide cap or an oxide beanie structure, followed by a Cu-damascene process to form the P-contacts 602. For instance, the deposition of the distributed Bragg reflector 601with the oxide cap may follow an etching of diaphragm, filling with Copper, and polishing the Copper (e.g. CMP) up to the oxide cap.

The distributed Bragg reflector 601 may be formed as a multi-layer reflector, with bilayers of Ta2O5 and SiO2 or with bilayers of Nb2O5 and SiO2. Said bilayers may be repeatedly stacked under λ/4 conditions (λ being the wavelength of the light to be emitted), and the reflectance or transmittance of the desired wavelength band may be increased by adjusting the thicknesses of individual layers and the number of stacked layers.

The process step may further comprise passivation with Aluminum metallization, e.g. N-side metallization, for facilitating front-side, e.g. P-side, interconnection.

As such, the resulting optical device 600 comprises the resonant cavity light emitting elements or RCLED modules 700, each comprising (from bottom to top as shown) the carrier substrate 501 including the contact pad 502, the metal layer 403 comprising the N-contact 403 hybrid bonded with the carrier substrate 501, the etch stop layer 203 on top of the metal layer 403, the N-GaN layer 204 on top of the etch stop layer 203, the emission layer 205 on top of the N-GaN layer 204, the P-GaN layer 206 on top of the emission layer 205, the ITO layer 207 on top of the P-GaN layer 206, the distributed Bragg reflector 601 on top of the ITO layer 207, and the P-contacts 602 conductively connected to the ITO layer 207.

In this regard, the cavity length for the RCLED module 700 is defined by the cavity structure, especially comprising the etch stop layer 203, the N-GaN layer 204, the emission layer 205, the P-GaN layer 206, and the ITO layer 207. In other words, the etch stop layer 203 defined one side, e.g. bottom side, of the cavity or cavity structure and the surface of the ITO layer 207 defines the other side, e.g. top side, of the cavity or cavity structure. The cavity can be defined with the full incorporation of the ITO thickness. The interfaces above the ITO and the N-GaN are the two boundary conditions. The metal layer 403 acts as the bottom side mirror and the distributed Bragg reflector 601 acts as the top side mirror, thereby facilitating the resonant cavity structure.

Generally, applications that require devices made in a compound semiconductor, especially are tightly co-integrated with CMOS logic, such as AR glasses, head up displays, micro-projectors, and the like need cost effective micro-LED displays with a very tight pitch (3µm or below), very large arrays (e.g. Full High Definition, 1920 x 1280 pixels). These applications further require integration of the micro-LED displays with optical system, like holographic waveguides, that require a specific emission angle from the light source to ensure good optical coupling and overall system efficiency.

Moreover, high brightness (1M nits) is also required for outdoors application. Standard LEDs are Lambertian emitters and thus inherently inefficient for light coupling to those optical solutions, while RCLED have much narrow emission angle and thus higher coupling efficiency. Furthermore, RCLEDs provide much higher electrical efficiency and thus less power consumption to achieve the required high brightness. Finally, the ability to process III-V compound semiconductor in an already established Si-CMOS 300 mm line ensures the most cost effective, and fast approach to the market.

The present invention proposes a new approach to fabricate RCLED on GaN material in a full CMOS environment with hybrid W2W bonding backplane integration for micro-LED displays using an innovative stopping layer for CMP etching for cavity length definition. The approach is defined by the ability to process III-V material in a 300mm CMOS line. The solution presented herein allows better electrical performances, lower consumption, better optical efficiency and in general better overall performances for micro-LED displays for various applications, enabling at the same time the cost-effective measures of a Si-CMOS 300mm line.

It is important to note that the word "comprising" does not exclude other elements or steps and the indefinite article "a" or "an" does not exclude a plurality. A single element or other unit may fulfill the functions of several entities or items recited in the claims. Moreover, the description with regard to any of the aspects is also relevant with regard to the other aspects of the invention.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application. The scope of the present invention is defined by the following claims.

## Claims

1. A method (100) for forming resonant cavity light emitting elements (700), the method comprising:
forming (101) a first structure (300) comprising a first substrate (201), an etch stop layer (203), a light emitting epitaxial structure (204, 205, 206), an optically transparent conductive oxide layer (207), and a second substrate (301) dielectrically bonded to the optically transparent conductive oxide layer (207),
etching (102) from the first substrate (201) up to the etch stop layer (203) to etch away the first substrate (201),
forming (103) a plurality of light emitting mesa modules (400), each having a metal layer (403) deposited on the etch stop layer (203),
hybrid bonding (104) the previously etched first structure (300) to a carrier substrate (501) to form a second structure (500),
etching (105) from the second substrate (301) up to the optically transparent conductive oxide layer (207), and
depositing (106) a distributed Bragg reflector (601) on top of the optically transparent conductive oxide layer (207), thereby forming the resonant cavity light emitting elements (700).

2. The method according to claim 1,
wherein a thickness of the etch stop layer (203), the light emitting epitaxial structure (204, 205, 206), and the optically transparent conductive oxide layer (207), collectively, defines a cavity length for the resonant cavity light emitting elements (700), preferably corresponding to one wavelength of a light to be emitted by the resonant cavity light emitting elements (700) .

3. The method according to claim 1 or 2,
wherein the formation of the first structure (300) comprises the steps of:
growing a buffer layer (202), the etch stop layer (203), the light emitting epitaxial structure (204, 205, 206), and the optically transparent conductive oxide layer (207), successively, on the first substrate (201), the light emitting epitaxial structure successively having a first highly-doped layer (204), an emission layer (205), and a second highly-doped layer (206),
providing the etch stop layer (203) between the buffer layer (202) and the first highly-doped layer (204), and
dielectric bonding to the second substrate (301) at the optically transparent conductive oxide layer (207) to form the first structure (300) .

4. The method according to claim 3,
wherein the buffer layer (202) is an n-doped buffer layer, especially an n-type Gallium Nitride (nGaN) layer and/or the first highly-doped layer (204) is an n-doped layer, especially an n-type Gallium Nitride (nGaN) layer, and/or the second highly-doped layer (206) is a p-doped layer, especially a p-type Gallium Nitride (pGaN) layer, and/or the emission layer (205) is a quantum well layer, especially an Indium Gallium Nitride (InGaN) and/or Gallium Nitride (GaN) based multiple quantum well (MQW) multi-layer.

5. The method according to any of claims 1 to 4,
wherein the etch stop layer (203) is an Indium Gallium Nitride (InGaN) and/or Aluminum Indium Gallium Nitride (AlInGaN) and/or Aluminum Gallium Nitride (AlGaN) layer, or wherein the etch stop layer (203) is a dielectric layer, preferably an oxide based dielectric layer.

6. The method according to any of claims 1 to 5,
wherein the formation of the second structure (500) comprises the steps of:
flipping over the first structure (300) after forming the plurality of light emitting mesa modules (400), and
hybrid bonding the first structure (300) to the carrier substrate (501) comprising a plurality of contact pads (502) so as to bond the plurality of light emitting mesa modules (400) with the respective contact pads (502).

7. The method according to any of claims 1 to 6, wherein the optically transparent conductive oxide layer (207) comprises a transparent oxide based alloy.

8. The method according to any of claims 1 to 7,
wherein the metal layer (403) comprises a Titanium layer and/or an Aluminum layer and/or bilayers thereof.

9. The method according to any of claims 1 to 7,
wherein the metal layer (403) comprises a plurality of conductive layers, preferably Titanium based oxide layers and/or Hafnium based oxide layers and/or bilayers thereof.

10. The method according to any of claims 1 to 7,
wherein the metal layer (403) comprises a plurality of dielectric layers and at least one metallic layer to form a hybrid optical reflector.

11. The method according to any of claims 1 to 10,
wherein the distributed Bragg reflector (601) is a multi-layer oxide based reflector, preferably comprising Tantalum based oxide layers and/or Niobium based oxide layers and/or Silicon based oxide layers and/or bilayers thereof.

12. The method according to any of claims 1 to 11,
wherein the etching corresponds to a dry etching process and/or a chemical-mechanical planarization process and/or a combination thereof.

13. The method according to any of claims 1 to 12,
wherein the etch stop layer (203) has a thickness less than 20nm, preferably between 10nm to 20nm, more preferably between 10nm to 15nm.

14. An optical device (600) comprising a plurality of resonant cavity light emitting elements (700), each of the plurality of resonant cavity light emitting elements (700) comprises:
a common carrier substrate (501),
a metal layer (403) hybrid bonded with the common carrier substrate (501),
an etch stop layer (203) on top of the metal layer (403),
a first highly-doped layer (204) on top of the etch stop layer (203),
an emission layer (205) on top of the first highly-doped layer (204),
a second highly-doped layer (206) on top of the emission layer (205),
an optically transparent conductive oxide layer (207) on top of the second highly-doped layer (206), and
a distributed Bragg reflector (601) on top of the optically transparent conductive oxide layer (207), wherein the resonant cavity light emitting elements (700) are formed by:
forming a first structure (300) comprising a first substrate (201), the etch stop layer (203), a light emitting epitaxial structure (204, 205, 206) comprising the first highly-doped layer (204), the emission layer (205) and the second highly-doped layer (206), the conductive oxide layer (207), and a second substrate (301) dielectrically bonded to the conductive oxide layer (207),
etching from the first substrate (201) up to the etch stop layer (203) to etch away the first substrate (201),
forming a plurality of light emitting mesa modules (400), each having the metal layer (403) deposited on the etch stop layer (203),
hybrid bonding the previously etched first structure (300) to the carrier substrate (501) to form a second structure (500),
etching from the second substrate (301) up to the conductive oxide layer (207), and
depositing the distributed Bragg reflector (601) on top of the conductive oxide layer (207).

15. The optical device according to claim 14,
wherein the etch stop layer (203), the first highly-doped layer (204), the emission layer (205), the second highly-doped layer (206), and the optically transparent conductive oxide layer (207) are configured to define a cavity length for the resonant cavity light emitting elements (700), preferably corresponding to one wavelength of a light to be emitted by the resonant cavity light emitting elements (700).

## Patentansprüche

1. Ein Verfahren (100) zum Bilden von Lichtemissionselementen mit resonanter Kavität (700), wobei das Verfahren umfasst:
Bilden (101) einer ersten Struktur (300), die ein erstes Substrat (201), eine Ätzstoppschicht (203), eine lichtemittierende Epitaxie-Struktur (204, 205, 206), eine optisch transparente leitfähige Oxidschicht (207) und ein mit der optisch transparenten leitfähigen Oxidschicht (207) dielektrisch verbundenes zweites Substrat (301) aufweist,
Ätzen (102) von dem ersten Substrat (201) bis zur Ätzstoppschicht (203), um das erste Substrat (201) wegzuätzen,
Bilden (103) einer Mehrzahl an lichtemittierenden Mesa-Modulen (400), die jeweils eine auf der Ätzstoppschicht (203) abgeschiedene Metallschicht (403) aufweisen,
Hybridbonden (104) der zuvor geätzten ersten Struktur (300) an ein Trägersubstrat (501), um eine zweite Struktur (500) zu bilden,
Ätzen (105) von dem zweiten Substrat (301) bis zur optisch transparenten leitfähigen Oxidschicht (207), und
Aufbringen (106) eines verteilten Bragg-Reflektors (601) auf die optisch transparente leitfähige Oxidschicht (207), wodurch die Lichtemissionselemente mit resonanter Kavität (700) gebildet werden.

2. Das Verfahren nach Anspruch 1,
wobei eine Dicke der Ätzstoppschicht (203), die lichtemittierende Epitaxie-Struktur (204, 205, 206) und die optisch transparente leitfähige Oxidschicht (207) zusammen eine Kavitätlänge für die Lichtemissionselemente mit resonanter Kavität (700) definieren, welche vorzugsweise einer Wellenlänge eines von den Lichtemissionselementen mit resonanter Kavität (700) zu emittierenden Lichtes entspricht.

3. Das Verfahren nach Anspruch 1 oder 2,
wobei die Bildung der ersten Struktur (300) die folgenden Schritte umfasst:
Aufwachsen einer Pufferschicht (202), der Ätzstoppschicht (203), der lichtemittierenden Epitaxie-Struktur (204, 205, 206) und der optisch transparenten leitfähigen Oxidschicht (207) nacheinander auf dem ersten Substrat (201), wobei die lichtemittierende Epitaxie-Struktur nacheinander eine erste hochdotierte Schicht (204), eine Emissionsschicht (205) und eine zweite hochdotierte Schicht (206) aufweist,
Bereitstellen der Ätzstoppschicht (203) zwischen der Pufferschicht (202) und der ersten hochdotierten Schicht (204), und
dielektrisches Verbinden mit dem zweiten Substrat (301) an der optisch transparenten leitfähigen Oxidschicht (207), um die erste Struktur (300) zu bilden.

4. Das Verfahren nach Anspruch 3,
wobei die Pufferschicht (202) eine n-dotierte Pufferschicht ist, insbesondere eine Galliumnitridschicht vom n-Typ (nGaN), und/oder
die erste hochdotierte Schicht (204) eine n-dotierte Schicht ist, insbesondere eine Galliumnitridschicht vom n-Typ (nGaN), und/oder
die zweite hochdotierte Schicht (206) eine p-dotierte Schicht ist, insbesondere eine Galliumnitridschicht vom p-Typ (pGaN), und/oder
die Emissionsschicht (205) eine Quantentopfschicht ist, insbesondere eine auf Indiumgalliumnitrid (InGaN) und/oder Galliumnitrid (GaN) basierende Mehrfach-Quantentopf-Mehrfachschicht (MQW).

5. Das Verfahren nach einem der Ansprüche 1 bis 4,
wobei die Ätzstoppschicht (203) eine Indiumgalliumnitrid (InGaN)- und/oder Aluminiumindiumgalliumnitrid (AllnGaN)- und/oder Aluminiumgalliumnitrid (AIGaN)-Schicht ist, oder wobei die Ätzstoppschicht (203) eine dielektrische Schicht ist, vorzugsweise eine dielektrische Schicht auf Oxidbasis.

6. Das Verfahren nach einem der Ansprüche 1 bis 5,
wobei die Bildung der zweiten Struktur (500) die folgenden Schritte umfasst:
Umdrehen der ersten Struktur (300) nach der Bildung der Mehrzahl an lichtemittierenden Mesa-Modulen (400), und
Hybridbonden der ersten Struktur (300) mit dem Trägersubstrat (501), das eine Mehrzahl an Kontaktflächen (502) umfasst, um die Mehrzahl an lichtemittierenden Mesa-Modulen (400) mit den jeweiligen Kontaktflächen (502) zu verbinden.

7. Das Verfahren nach einem der Ansprüche 1 bis 6,
wobei die optisch transparente leitfähige Oxidschicht (207) eine transparente Legierung auf Oxidbasis aufweist.

8. Das Verfahren nach einem der Ansprüche 1 bis 7,
wobei die Metallschicht (403) eine Titanschicht und/oder eine Aluminiumschicht und/oder Doppelschichten davon aufweist.

9. Das Verfahren nach einem der Ansprüche 1 bis 7,
wobei die Metallschicht (403) eine Mehrzahl an leitfähigen Schichten aufweist, vorzugsweise Oxidschichten auf Titanbasis und/oder Oxidschichten auf Hafniumbasis und/oder Doppelschichten davon.

10. Das Verfahren nach einem der Ansprüche 1 bis 7,
wobei die Metallschicht (403) eine Mehrzahl an dielektrische Schichten und zumindest eine Metallschicht aufweist, um einen hybriden optischen Reflektor zu bilden.

11. Das Verfahren nach einem der Ansprüche 1 bis 10,
wobei der verteilte Bragg-Reflektor (601) ein mehrschichtiger Reflektor auf Oxidbasis ist, welcher vorzugsweise Oxidschichten auf Tantalbasis und/oder Oxidschichten auf Niobbasis und/oder Oxidschichten auf Siliziumbasis und/oder Doppelschichten davon umfasst.

12. Das Verfahren nach einem der Ansprüche 1 bis 11,
wobei das Ätzen einem Trockenätzverfahren und/oder einem chemisch-mechanischen Planarisierungsverfahren und/oder einer Kombination davon entspricht.

13. Das Verfahren nach einem der Ansprüche 1 bis 12,
wobei die Ätzstoppschicht (203) eine Dicke von weniger als 20 nm, vorzugsweise zwischen 10 nm und 20 nm, noch bevorzugter zwischen 10 nm und 15 nm aufweist.

14. Eine optische Vorrichtung (600) mit einer Mehrzahl an Lichtemissionselementen mit resonanter Kavität (700), wobei jedes der Mehrzahl an Lichtemissionselementen mit resonanter Kavität (700) aufweist:
ein gemeinsames Trägersubstrat (501),
eine Metallschicht (403), die an das gemeinsame Trägersubstrat (501) hybridgebunden ist,
eine Ätzstoppschicht (203) auf der Metallschicht (403),
eine erste hochdotierte Schicht (204) auf der Ätzstoppschicht (203),
eine Emissionsschicht (205) auf der ersten hochdotierten Schicht (204),
eine zweite hochdotierte Schicht (206) auf der Emissionsschicht (205),
eine optisch transparente leitfähige Oxidschicht (207) auf der zweiten hochdotierten Schicht (206), und
einen verteilten Bragg-Reflektor (601) auf der optisch transparenten leitfähigen Oxidschicht (207),
wobei die Lichtemissionselemente mit resonanter Kavität (700) gebildet werden durch:
Bilden einer ersten Struktur (300) mit einem ersten Substrat (201), der Ätzstoppschicht (203), einer die erste hochdotierte Schicht (204), die Emissionsschicht (205) und die zweite hochdotierte Schicht (206) aufweisenden lichtemittierenden Epitaxie-Struktur (204, 205, 206), der leitfähigen Oxidschicht (207) und einem mit der leitfähigen Oxidschicht (207) dielektrisch verbundenen zweiten Substrat (301),
Ätzen vom ersten Substrat (201) bis zur Ätzstoppschicht (203), um das erste Substrat (201) wegzuätzen,
Bilden einer Mehrzahl an lichtemittierenden Mesa-Modulen (400), die jeweils die auf der Ätzstoppschicht (203) abgeschiedene Metallschicht (403) aufweisen,
Hybridbonden der zuvor geätzten ersten Struktur (300) mit dem Trägersubstrat (501), um eine zweite Struktur (500) zu bilden,
Ätzen vom zweiten Substrat (301) bis zur leitfähigen Oxidschicht (207), und
Aufbringen des verteilten Bragg-Reflektors (601) auf die leitfähige Oxidschicht (207).

15. Die optische Vorrichtung nach Anspruch 14,
wobei die Ätzstoppschicht (203), die erste hochdotierte Schicht (204), die Emissionsschicht (205), die zweite hochdotierte Schicht (206) und die optisch transparente leitfähige Oxidschicht (207) so konfiguriert sind, dass sie für die Lichtemissionselemente mit resonanter Kavität (700) eine Kavitätlänge definieren, welche vorzugsweise einer Wellenlänge eines von den Lichtemissionselementen mit resonanter Kavität (700) zu emittierenden Lichts entspricht.

## Revendications

1. Un procédé (100) pour former des éléments électroluminescents à cavité résonante (700), le procédé comportant de :
former (101) une première structure (300) comportant un premier substrat (201), une couche d'arrêt de gravure (203), une structure épitaxiale électroluminescente (204, 205, 206), une couche d'oxyde conducteur optiquement transparent (207), et un second substrat (301) diélectriquement relié à la couche d'oxyde conducteur optiquement transparent (207),
graver (102) à partir du premier substrat (201) jusqu'à la couche d'arrêt de gravure (203) pour ôter par gravure le premier substrat (201),
former (103) une pluralité de modules mesa électroluminescents (400), chacun ayant une couche de métal (403) déposée sur la couche d'arrêt de gravure (203),
assembler de façon hybride (104) la première structure (300) précédemment gravée à un substrat porteur (501) pour former une seconde structure (500),
graver (105) à partir du second substrat (301) jusqu'à la couche d'oxyde conducteur optiquement transparent (207), et déposer (106) un réflecteur de Bragg réparti (601) au-dessus de la couche d'oxyde conducteur optiquement transparent (207), en formant ainsi les éléments électroluminescents à cavité résonante (700).

2. Le procédé selon la revendication 1,
dans lequel une épaisseur de la couche d'arrêt de gravure (203), de la structure épitaxiale électroluminescente (204, 205, 206) et de la couche d'oxyde conducteur optiquement transparent (207), collectivement, définit une longueur de cavité pour les éléments électroluminescents à cavité résonante (700), correspondant de préférence à une longueur d'onde d'une lumière à émettre par les éléments électroluminescents à cavité résonante (700).

3. Le procédé selon la revendication 1 ou 2,
dans lequel la formation de la première structure (300) comporte les étapes consistant à :
faire croître une couche tampon (202), la couche d'arrêt de gravure (203), la structure épitaxiale électroluminescente (204, 205, 206) et la couche d'oxyde conducteur optiquement transparent (207), successivement, sur le premier substrat (201), la structure épitaxiale électroluminescente ayant successivement une première couche fortement dopée (204), une couche d'émission (205) et une seconde couche fortement dopée (206),
disposer la couche d'arrêt de gravure (203) entre la couche tampon (202) et la première couche fortement dopée (204),
et
relier diélectriquement le second substrat (301) au niveau de la couche d'oxyde conducteur optiquement transparent (207) pour former la première structure (300).

4. Le procédé selon la revendication 3,
dans lequel la couche tampon (202) est une couche tampon dopée n, en particulier une couche de nitrure de gallium de type n (nGgaN) et/ou la première couche fortement dopée (204) est une couche dopée n, en particulier une couche de nitrure de gallium de type n (nGaN), et/ou la seconde couche fortement dopée (206) est une couche dopée p, en particulier une couche de nitrure de gallium de type p (pGaN) et/ou la couche d'émission (205) est une couche de puits quantiques, en particulier une multicouche à multi-puits quantiques (MQW) de nitrure d'indium et de gallium (InGaN) et/ou de nitrure de gallium (GaN).

5. Le procédé selon l'une quelconque des revendications 1 à 4,
dans lequel la couche d'arrêt de gravure (203) est une couche de nitrure d'indium et de gallium (InGaN) et/ou de nitrure d'aluminium, de gallium et d'indium (AlInGaN) et/ou de nitrure d'aluminium et de gallium (AlGaN), ou la couche d'arrêt de gravure (203) est une couche diélectrique, de préférence une couche diélectrique à base d'oxyde.

6. Le procédé selon l'une quelconque des revendications 1 à 5,
dans lequel la formation de la seconde structure (500) comporte les étapes consistant à :
retourner la première structure (300) après la formation de la pluralité de modules mesa électroluminescents (400), et
assembler de façon hybride la première structure (300) au substrat porteur (501) comportant une pluralité de plages de contact (502) de manière à assembler la pluralité de modules mesa électroluminescents (400) aux plages de contact (502) respectives.

7. Le procédé selon l'une quelconque des revendications 1 à 6,
dans lequel la couche d'oxyde conducteur optiquement transparent (207) comporte un alliage à base d'oxyde transparent.

8. Le procédé selon l'une quelconque des revendications 1 à 7,
dans lequel la couche de métal (403) comporte une couche de titane et/ou une couche d'aluminium et/ou des bicouches de celles-ci.

9. Le procédé selon l'une quelconque des revendications 1 à 7,
dans lequel la couche de métal (403) comporte une pluralité de couches conductrices, de préférence des couches d'oxyde à base de titane et/ou des couches d'oxyde à base de hafnium et/ou des bicouches de celles-ci.

10. Le procédé selon l'une quelconque des revendications 1 à 7,
dans lequel la couche de métal (403) comporte une pluralité de couches diélectriques et au moins une couche de métal pour former un réflecteur optique hybride.

11. Le procédé selon l'une quelconque des revendications 1 à 10,
dans lequel le réflecteur de Bragg réparti (601) est un réflecteur à base d'oxyde multicouche, comportant de préférence des couches d'oxyde à base de tantale et/ou des couches d'oxyde à base de niobium et/ou des couches d'oxyde à base de silicium et/ou des bicouches de celles-ci.

12. Le procédé selon l'une quelconque des revendications 1 à 11,
dans lequel la gravure correspond à un processus de gravure sèche et/ou un processus de planarisation chimio-mécanique et/ou une combinaison de ceux-ci.

13. Le procédé selon l'une quelconque des revendications 1 à 12,
dans lequel la couche d'arrêt de gravure (203) a une épaisseur inférieure à 20 nm, de manière préférée entre 10 nm et 20 nm, de manière plus préférée entre 10 nm et 15 nm.

14. Un dispositif optique (600) comportant une pluralité d'éléments électroluminescents à cavité résonante (700), chaque élément de la pluralité d'éléments électroluminescents à cavité résonante (700) comportant :
un substrat porteur commun (501),
une couche de métal (403) assemblée de façon hybride au substrat porteur commun (501),
une couche d'arrêt de gravure (203) au-dessus de la couche de métal (403),
une première couche fortement dopée (204) au-dessus de la couche d'arrêt de gravure (203),
une couche d'émission (205) au-dessus de la première couche fortement dopée (204),
une seconde couche fortement dopée (206) au-dessus de la couche d'émission (205),
une couche d'oxyde conducteur optiquement transparent (207) au-dessus de la seconde couche fortement dopée (206), et
un réflecteur de Bragg réparti (601) au-dessus de la couche d'oxyde conducteur optiquement transparent (207), dans lequel les éléments électroluminescents à cavité résonante (700) sont formés par les étapes consistant à :
former une première structure (300) comportant un premier substrat (201), la couche d'arrêt de gravure (203), une structure épitaxiale électroluminescente (204, 205, 206) comportant la première couche fortement dopée (204), la couche d'émission (205) et la seconde couche fortement dopée (206), la couche d'oxyde conducteur (207) et un second substrat (301) diélectriquement relié à la couche d'oxyde conducteur (207),
graver à partir du premier substrat (201) jusqu'à la couche d'arrêt de gravure (203) pour ôter par gravure le premier substrat (201),
former une pluralité de modules mesa électroluminescents (400), chacun ayant la couche de métal (403) déposée sur la couche d'arrêt de gravure (203),
assembler de façon hybride la première structure (300) précédemment gravée au substrat porteur (501) pour former une seconde structure (500),
graver à partir du second substrat (301) jusqu'à la couche d'oxyde conducteur (207), et
déposer le réflecteur de Bragg réparti (601) au-dessus de la couche d'oxyde conducteur (207).

15. Le dispositif optique selon la revendication 14,
dans lequel la couche d'arrêt de gravure (203), la première couche fortement dopée (204), la couche d'émission (205), la seconde couche fortement dopée (206) et la couche d'oxyde conducteur optiquement transparent (207) sont configurées pour définir une longueur de cavité pour les éléments électroluminescents à cavité résonante (700), correspondant de préférence à une longueur d'onde d'une lumière à émettre par les éléments électroluminescents à cavité résonante (700).
